# EUROPEAN PATENT APPLICATION

(11) **EP 3 403 992 A1**
(43) Date of publication of application: **21.11.2018**
(21) Application number: 18161337.3
(22) Date of filing: 12.03.2018
(51) Int. Cl.: B81B 7/02, B81C 1/00

(54) **SYSTEMS AND METHODS FOR MULTI-SENSOR INTEGRATED SENSOR DEVICES**

(30) Priority: 15.05.2017 US 201762506121 P; 22.08.2017 US 201715683573
(71) Applicant: Honeywell International Inc., Morris Plains, NJ 07950 (US)
(72) Inventor: ENDEAN, Daniel, Morris Plains, NJ New Jersey 07950 (US); ROBERTS, Barry A., Morris Plains, NJ New Jersey 07950 (US)
(74) Representative: Houghton, Mark Phillip

(57) **Abstract**

Systems and methods for multi-sensor integrated sensor devices are provided. In one embodiment, a sensor device comprises: a substrate having a first surface and an opposing second surface; a plurality of sensor cavities recessed into the substrate; a first sensor die sealed within a first sensor cavity of the plurality of sensor cavities at a first atmospheric pressure level; a second sensor die sealed within a second sensor cavity of the plurality of sensor cavities at a second atmospheric pressure level that is a different pressure than the first atmospheric pressure level; a first plurality of direct feedthrough electrical conductors embedded within the substrate coupled to the first sensor die; and a second plurality of direct feedthrough electrical conductors embedded within the substrate coupled to the second sensor die.

## Description

### CROSS-REFERENCE TO RELATED APPLICATIONS

This applications claims priority to, and the benefit of, U.S. Provisional Patent Application No. 62/506,121 titled, **"MULTI-SENSOR INTEGRATED MEMS PACKAGES"** filed on May 15, 2017 and which is incorporated herein by reference in its entirety.

### STATEMENT REGARDING FEDERALLY SPONSORED RESEARCH OR DEVELOPMENT

This invention was made with U.S. Government support under Government Contract Number N66001-12-C-4178 awarded by SPAWAR Systems Center Pacific. The U.S. Government has certain rights in the invention.

### BACKGROUND

Inertial Measurements Units (IMUs) are sensor devices mounted onto moving platforms to sense accelerations and rotations of the platform. For example, IMUs may be employed in navigation systems of aircraft or other vehicles, or used in personal consumer devices such as but not limited to cell phones, military applications, or in industrial applications such as robotics and/or machine tools. In each case, the IMU may serve to determine the platform's relative orientation (or attitude) with respect to some frame of reference, and/or assist in determining the platform's position with respect to a frame of reference. Because there is an ongoing desire to miniaturize these platforms and their electronics, there is a corresponding desire to miniaturize the IMUs used on these platforms. Micro electro-mechanical systems (MEMS) sensors are one an example of a technology used for realizing small IMUs. MEMS sensors are fabricated from Silicon (Si) and glass materials (for example) and include moving components that are sensitive to motions and accelerations. For example, in existing technology, each inertial sensor comprises a sensor die that is housed within its own individual device package. This device package seals the sensor die in an appropriate atmosphere for that die (for example, a vacuum or partial vacuum), provides electrical connection to electrical components outside of the device package (for example, using wire bonding), and provides mechanical stability by matching material properties (for example thermal expansion coefficients) between the package and the sensor die. The device package is then mounted to a circuit board. Typically, several such MEMS sensor device packages would be mounted to the circuit board to facilitate sensor measurements across multiple sensing axes. For example to arrive at a device for measuring six independent inertial quantities, six separately packaged sensors (typically three accelerometers and three gyroscopes) would be mounted to the circuit board, which provides electrical connection to discrete electronic components and application-specific integrated circuits (ASICs) to operate the sensors in their device packages. Honeywell's HG4930 is one example of a commercially available IMU that contains two 1.6" diameter circuit boards to operate 6 sensors along with an additional 1.8" diameter board hosting the mission processor for the system. The complete IMU occupies a volume of ∼4.5 cu. in. However, as IMU designs become increasingly miniaturized, there is less volume available on printed circuit boards to accommodate MEMS sensors, the packages that house them, and the circuit board mounted electronic components to operate the sensors.

For the reasons stated above and for other reasons stated below which will become apparent to those skilled in the art upon reading and understanding the specification, there is a need in the art for Multi-Sensor Integrated MEMS Packages.

### SUMMARY

Embodiments of the present disclosure provide systems and methods for multi-sensor integrated sensor devices and will be understood by reading and studying the following specification.

Systems and methods for multi-sensor integrated sensor devices are provided. In one embodiment, a sensor device comprises: a substrate having a first surface and an opposing second surface; a plurality of sensor cavities recessed into the substrate; a first sensor die sealed within a first sensor cavity of the plurality of sensor cavities at a first atmospheric pressure level; a second sensor die sealed within a second sensor cavity of the plurality of sensor cavities at a second atmospheric pressure level that is a different pressure than the first atmospheric pressure level; a first plurality of direct feedthrough electrical conductors embedded within the substrate coupled to the first sensor die; and a second plurality of direct feedthrough electrical conductors embedded within the substrate coupled to the second sensor die.

### DRAWINGS

Embodiments of the present disclosure can be more easily understood and further advantages and uses thereof more readily apparent, when considered in view of the description of the preferred embodiments and the following figures in which:
Figures 1, 2 and 2A are simplified block diagrams illustrating an inertial sensor assembly for an IMU of one embodiment of the present disclosure.
Figure 2B is a diagram illustrating an example embodiment wherein one or more integrated circuit die are mounted within cavities recessed into the substrate of an ISA such as the substrate of Figure 1.
Figure 2C is a diagram illustrating an example embodiment wherein a processing unit is incorporated onto the substrate of an ISA such as the substrate of Figure 1.
Figures 3 and 4 are diagrams illustrating an ISA comprising a mechanical isolation system of one embodiment of the present disclosure.
Figure 5 is a flow chart illustrating an example process of one embodiment of the present disclosure.

In accordance with common practice, the various described features are not drawn to scale but are drawn to emphasize features relevant to the present disclosure. Reference characters denote like elements throughout figures and text.

### DETAILED DESCRIPTION

In the following detailed description, reference is made to the accompanying drawings that form a part hereof, and in which is shown by way of specific illustrative embodiments in which the embodiments may be practiced. These embodiments are described in sufficient detail to enable those skilled in the art to practice the embodiments, and it is to be understood that other embodiments may be utilized and that logical, mechanical and electrical changes may be made without departing from the scope of the present disclosure. The following detailed description is, therefore, not to be taken in a limiting sense.

Embodiments disclosed herein present techniques for miniaturizing electronics in inertial measurement units (IMU) that can support multiple inertial sensors simultaneously. For example, in one example of a high performing 6-axis IMU, there are 6 inertial sensors: three accelerometers and three gyroscopes. As opposed to fabricating each inertial sensor in its own separate device package, the embodiments disclosed herein may be used to realize a complete 6-axis sensor assembly within a single package having a full sensor suite of sensor die on a common substrate which provides mechanical attachment and electrical connections and provide for the die and substrate materials having material properties matching those of the sensors. As explained below, some embodiments allow the volume occupied by tactical-grade inertial sensors and their supporting electronics to be reduced significantly (for example, by a factor of three). In some embodiments, the sensor die may comprise micro electro-mechanical systems (MEMS) devices. However, it should be understood that embodiments within the scope of the present disclosure are not strictly limited to MEMS device and that for any of the embodiments discussed or illustrated in this specification that comprise MEMS devices, non-MEMS devices may take the place of those MEMS devices. As one example, any of the sensor die described in embodiments below may alternately comprise a Quartz crystal based device, or a chip-scale solid state electronic device, rather than a MEMS device. Similarly, any of the sensor die described in embodiments below may alternately comprise a chip-scale atomic clock or other chip-scale atomic device. It should also be appreciated that while gyroscopes and accelerometers are the primary examples provided below, specification of such devices is for illustrative purposes. In the embodiments described below, the sensor die may comprise any of, but are not limited to, gyroscope sensor die, accelerometer sensor die, magnetometer sensor die, temperature sensor die, pressure sensor die, or a clock die, for example.

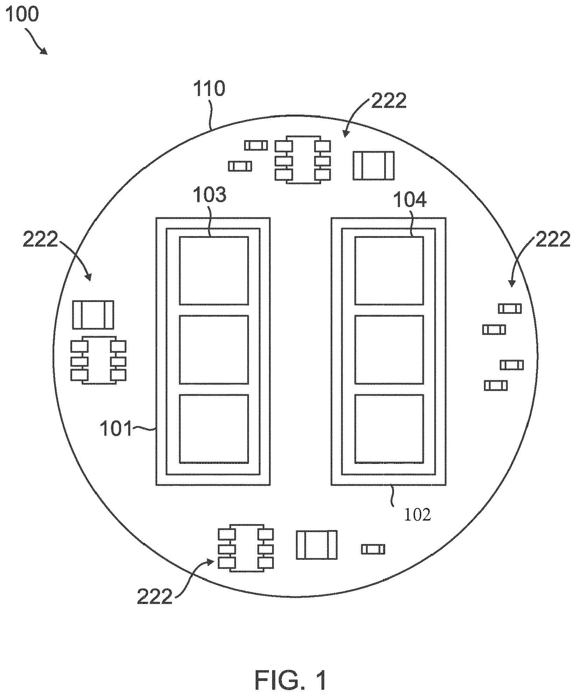

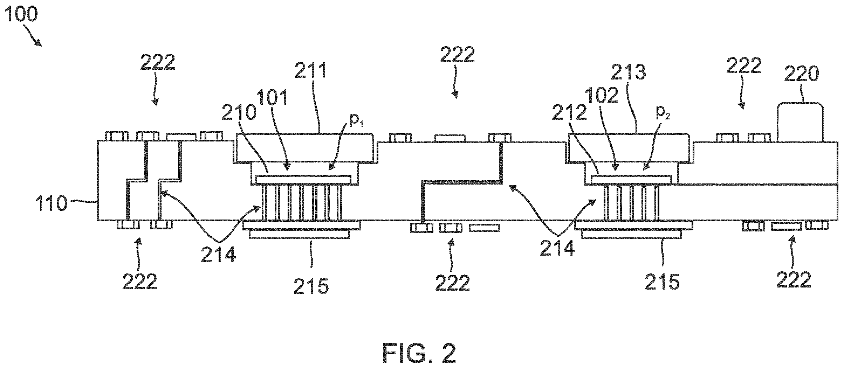

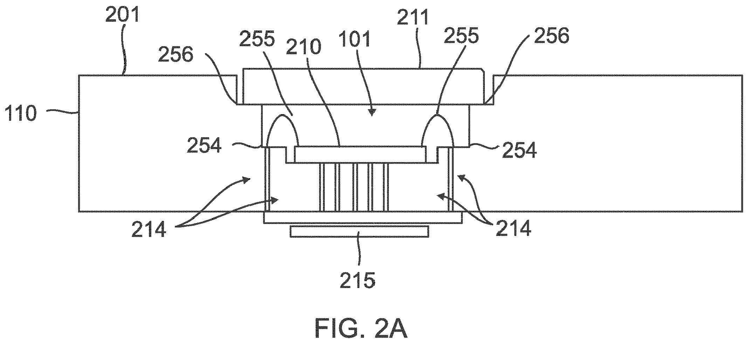

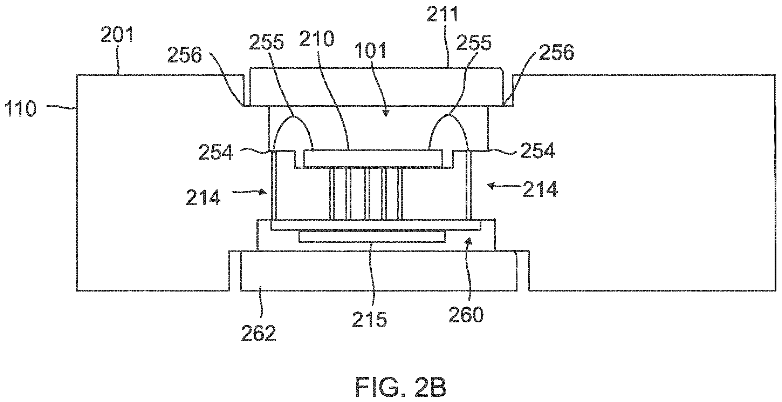

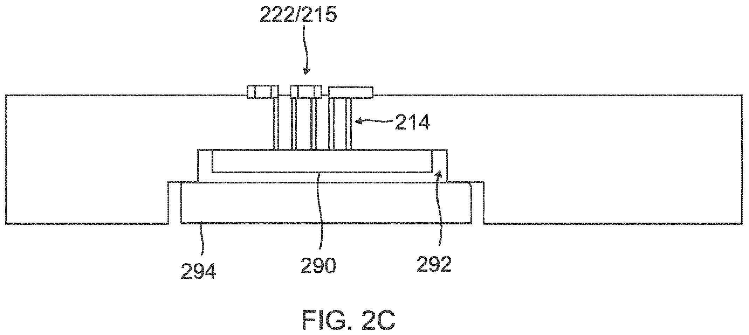

Figures 1, 2 and 2A are simplified block diagrams illustrating an Inertial Sensor Assembly (ISA) 100 for an IMU of one embodiment of the present disclosure. In Figure 1, an examiner top view of ISA 100 is shown with a substrate 110 of ceramic or similar material fabricated to provide a multilevel circuit board having direct electrical conducting paths, traces, mounting pads and feedthroughs and supporting electrically connecting active and passive device components. In some embodiments, substrate 110 is planar in shape.

For example, in the example embodiments of Figure 1, two sensor cavities are shown at 101 and 102. In this example, the cavities 101 and 102 are placed near the center of the substrate 110. In other implementations, they may be placed elsewhere. In this embodiment, each of the cavities 101 and 102 will house different types of MEMS sensor die. For example, in one embodiment, the first cavity 101 may include 3 gyroscope sensor die (shown at 103) while the second cavity 102 may include 3 accelerometer sensor die (shown at 104). It should be understood however that while throughout this disclosure, gyroscope and accelerometer die may be used as illustrative examples, other combinations of MEMS sensor die may instead or also occupy a sensor cavity such as, but not limited to magnetometers, temperature sensors, pressure sensors, and the like. In one embodiment, the input axes of the inertial sensors are oriented so that all six independent inertial quantities can be measured (that is, acceleration and rotation each with respect to 3 orthogonal axes). That is, in some embodiments, sensor measuring the same parameters may be included in a common cavity although the individual die for each sensor is either structured and/or oriented differently to measure its parameter along a different axis. In some embodiments different combinations of co-planar sensor designs may be employed together to achieve the 3 orthogonal axes for a given inertial motion. As such, with embodiments of the present disclosure, the substrate 110 may have defined within its volume a plurality of cavities in which diverse sets of MEMS sensor die are housed and sealed.

It should be appreciated that, to the degree that the material properties of the sensor die 103, 104 are different than that of the substrate 110 to which they are mounted, the sensor die 103, 104 may react differently to changes in environmental conditions in such a way as to create a sensor bias or other measurement errors. This is especially true of with respect to thermal expansion. That is, if the MEMS sensor die 103, 104 and the substrate 110 have differing coefficients of thermal expansion, each will expand and contract in response to changing thermal conditions differently, producing stresses in the sensor die which may manifest themselves as measurement errors. The degree to which these measurement errors are tolerable depends on the grade of the IMU and its intended use. For example, while a rotation rate measurement error of 1000 degrees/hour may be expected and tolerable for a commercial grade IMU, a tactical grade IMU (for example, one used for navigation purposes on airborne platforms) would need to demonstrate a rotation rate measurement error of less than 30 degrees/hour.

In some embodiments, the substrate 110 may be fabricated from a material selected to have thermal expansion properties matching the material of the MEMS sensor die 103, 104. For example, for embodiments where the MEMS sensor die 103, 104 mounted within the cavities 101 and 102 are fabricated from a Silicon (Si)/ Glass material, then the substrate 110 is fabricated from a material selected to have thermal expansion properties matching that Silicon (Si)/ Glass material. For example, in some embodiments the substrate 110 may be a high-temperature co-fired ceramic material such as but not limited to an Aluminum Oxide (such Al₂O₃, often referred to as "Alumina"). Such material has an expansion coefficient very similar to Silicon (Si)/ Glass materials often used for fabricating MEMS sensors. However, this example should not be considered as limited as not all MEMS are necessarily composed of Si and Glass. Furthermore material properties may vary across different types of glass and Si. Silicon Carbide (SiC) and/or some plastic materials are other examples of materials which may be formulated to have matching thermal expansion properties as Silicon (Si)/ Glass material MEMS sensor die. Still other materials may be used providing they have sufficient electrical insulating properties suitable for a substrate facilitating electrical circuits as described herein.

It should be noted that utilizing ceramics as a material for substrate 110 further provides additional benefits over traditional printed circuit board in terms of resistance to shock, vibration, and aging. High performance IMUs are expected to maintain accurate outputs over long shelf lives and in challenging environments that in include temperature, vibration, and mechanical shock. A ceramic substrate is stronger, resistance bending under large accelerations is better, and may be expected to resist the effects of humidity as well. It should therefore be understood that one of 'skill in the art' who has studied this disclosure would thus be able to select a material for substrate 110 based on the grade of IMU and measurement error their particular system can tolerate.

The material of substrate 110 further includes electrical vias, traces, pathways and bonding points (referred to herein as "feedthrough electrical conductors") for electrically connecting elements between multiple insulating layers of the substrate and its surfaces so that all electrical connections are performed within the ceramic material (for example) of the substrate 110. For example, in one embodiment the MEMS sensor die 103, 104 are bonded to electrical pads positioned on the floor of cavities 101, 102 in order to interconnect the MEMS sensor die 103, 104 with other electronic components of the ISA 100.

In any of the embodiments described herein, the sensor die may be electrically connected to the direct feedthrough electrical conductors via pads or other bonding points using one of any number of known die attachment methodologies such as, but not limited to a solder reflow, bump bond, underfilling, or other known methodology. Moreover, one or more wirebonds (which will be sealed within their respective sensor cavities) may be fabricated to electrically couple the sensor die to one or more of the direct feedthrough electrical conductors.

Figure 2 is a side view cross-sectional diagram of the ISA 100 shown in Figure 1. As illustrated in Figure 2, the substrate 110 comprises a first sensor die (or first set of a plurality of die) 210 sealed by a first lid 211 within a first cavity 101 recessed into the material of the substrate 110. The substrate 110 further comprises a second sensor die (or second set of a plurality of die 212) sealed by a second lid 213 within a second cavity 102 recessed into the material of the substrate 110. As mentioned above, the die 210 may measure parameters diverse from the parameters measured by die 212. In some embodiments, a cavity lid may be used in conjunction with a seal ring.

Passive and active electronic components (shown at 222) may be positioned on either surface 201, 202 of the substrate 110 and interconnected by one or more direct electrical pathways and feedthrough electrical conductors 214 embedded within the substrate 110. One or more analog and/or digital integrated circuits 215 may further be bonded to the substrate 110 and interconnected with the MEMS sensor die 210, 212 mounted within the first and second cavities 101, 102 and/or with the passive and active electronic components 222 by the direct electrical pathways and feedthrough conductors 214.

To optimize performance, in some embodiments, integrated circuits 215 may comprise application specific integrated circuits (ASICs) designed to condition the electrical signals received and sent to the sensor die 210, 212 and that may be placed directly opposite one of the sensor die 210, 212. In some embodiments, integrated circuits 215 may also comprise, processing units, an analog-to-digital converter, a digital-to-analog converter, active and/or passive electronic components, clocks or other sensors, for example.

Other electrical components including passive electrical components (for example, capacitors, resistors and inductors), active circuits (for example, transistor circuits, amplifiers and op-amps), and external connectors are soldered onto attachment points or pads on the board. For example, as shown in Figure 2, in some embodiments, integrated circuits 215 used for processing the signals from the sensor die 210, 212 may be, but are not necessarily, positioned on the opposing side of the substrate 110 from the sensor die 210, 212, and optionally may be directly aligned with the sensor die 210, 212, to optimize the electrical path and therefore minimize potential for noise from cross-talk or other interference such as parasitic capacitance from affecting the measurement signals. In some embodiments, the sensor die 210, 212 may be recessed into the same surface of substrate 110, but in other embodiments may be recessed into different surfaces. As shown in Figure 2, the ISA 100 may also include at least one sensor I/O connector port 220 which may be coupled to the direct electrical pathways and feedthrough conductors 214, components 222 and integrated circuits 215, and outputs inertial measurements (for example, accelerations and rotation rates) out from ISA 100 to other devices. I/O connector port 220 may be implemented as either a wired or wireless I/O port.

In some embodiments, to accommodate the appropriate environmental conditions for operation of MEMS sensors that measure different parameters, the MEMS sensor die sealed within different sensor cavities may be sealed within those cavities at different environmental pressures and/or using environments of different gasses within those cavities. For example, in Figure 2, the MEMS sensor die 210 may be sealed within sensor cavity 101 of substrate 110 at an atmospheric pressure (or vacuum level), p₁, that is greater or less than the atmospheric pressure, p₂, within which sensor die 212 is sealed within the second sensor cavity 102 of substrate 110. For example, in one embodiment, the first sensor die 210 may comprise one or more gyroscopes while the second sensor die 212 may comprise one of more accelerometers. MEMS gyroscope die are designed to operate under high vacuum environments to avoid air dampening. In contrast MEMS accelerometer die are designed to operate under partial atmosphere conditions in the presence of a gas in order to provide a prescribed amount of air dampening. As such, with some embodiments of the present disclosure, the first cavity 101 is sealed to hold the first sensor die 210 under a different atmospheric pressure (for example, a different psi) than the second cavity 102 which holds the second sensor die 212. In some embodiments, to assist in maintaining a desired level of vacuum environment in a cavity 101 or 102, the corresponding first lid 211 or second lid 213 may comprise a getter to scavenge any gasses remaining in the cavity post-manufacturing, or that may leak into cavity over time.

As shown in Figure 2A in some embodiments, one or more of the cavities may include multiple levels of steps or shelves to facilitate recessing their lid into the substrate 110 and or to facilitate wire bond connections to the MEMS sensor die within the cavity. In the particular example illustrated in Figure 2A, the cavity includes a first shelf 254 aligned with the approximate height of the top of the inertial sensor die 210 to allow electrical connections 255 (e.g. wire bonds) from the sensor die 210 to connect to one or more of the electrical conductors 214 embedded within substrate 110. A second shelf 256 is recessed in from the top surface 257 to allow the top of the cavity lid 211 to be flush with a surface (for example, 201 or 202) of the substrate 110.

In one alternative embodiment, shown in Figure 2B, one or more of the integrated circuits 215 are placed opposite the respective sensor die 210, 212 within their own cavities 260 recessed into substrate 110 (and optionally sealed by lid 262) to avoid the need for separately packaging each ASIC 215 in its own package. That is, as opposed to residing within their own device packaging, in some embodiments, one or more of the ASIC 215 may comprise an integrated circuit die bonded to the substrate 110 within cavity 260 and optionally sealed by a lid 262 in the same manner as otherwise described herein for a MEMS sensor die. The environmental pressure within the sealed cavity 260 may be the same or different than those for either of the respective sensor die 210, 212.

Alternative embodiments may utilize either a greater or fewer number of cavities depending on the number of sensor die involved and/or their requirements for different environments. For example, sensor die that measure different parameters but which may operate in the same atmospheric environment (e.g. pressure) may share a cavity. Yet another embodiment includes incorporating a processing unit 290 onto the substrate 110, such as shown in Figure 2C, so that it functions as an inertial measurement unit (IMU) capable of providing navigation solutions (for example). In some embodiments, the processing unit 290 may comprise a processor die within a cavity 292 and optionally sealed by a lid 294 as some atmospheric pressure in the same manner as otherwise described herein for a MEMS sensor die. The processing unit 290 may be coupled to one or more active or passive components 222, integrated circuits 215 and/or any of the other components on and/or in substrate 110 described herein via feedthrough electrical conductors 214.

As opposed to relying on packaged sensors, the embodiments described herein provide for sensor assemblies where the individual sensor die may be fabricated and oriented directly on a substrate and permitting selection of the exact combination of high performing sensors for a particular application, while optimizing the total volume of the resulting device. For example, if a row of three sensors on the same chip were bonded within a device package, such bonds would either be spatially separated by a large distance inducing stress or some of the sensor die would be cantilevered at the edge of the die which would be non-ideal. The embodiments described herein allow for production and bonding of sensor die individually and directly within sensor cavities avoiding compromises associated with die within device packages. Moreover, as described herein, similar sensor die (for example, that measure the same parameters or that can operate under the same environment) may be bonded to the substrate within the same cavity under a single lid to further optimize volume. By incorporating multiple cavities into one substrate that also incorporates integrated circuits, the volumes associated with attaching discrete components with conventional circuit board assembly techniques are eliminated.

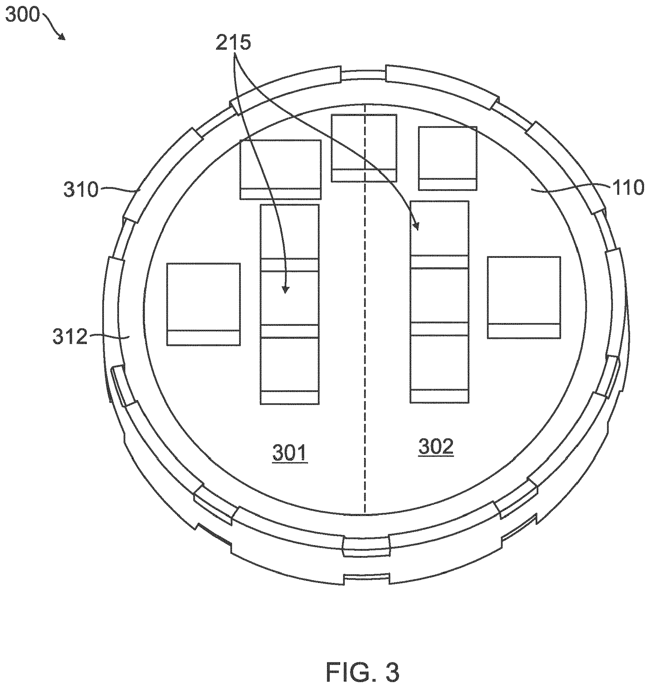

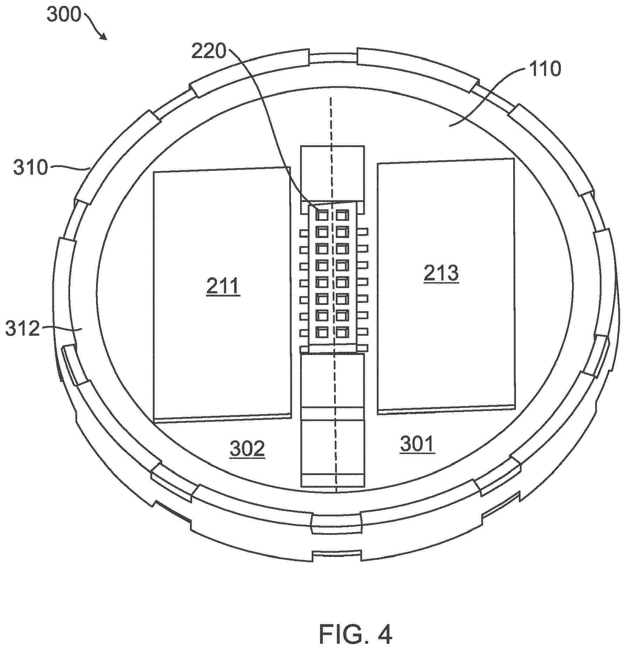

Figures 3 and 4 are examples of an ISA 100 mounted within a mechanical isolation system 300 to dampen high frequency vibrations and/or prevent damage to the ISA 100 during extreme acceleration events. System 300 is an example of a damped flexible suspension structure that couples the ISA 100 to another structure such as, but not limited to, an outer housing of the IMU. For example, in one embodiment the mechanical isolation system 300 comprises a rigid support ring 310 and an elastomer material 312. The rigid support ring 310 would be mounted to an outer housing of the IMU (or to the larger external structure employing the IMU) while the substrate 110 is coupled to and supported within that structure by the elastomer material 312, thus isolating the substrate 110 and components mounted to it from physical contact with any other components within the housing or structure.

In other embodiments, a mechanical isolation system supporting the ISA 100 may comprise other materials which achieve vibration isolation. It may comprise vibration isolation elements attached to one or more of the sides, top or bottom of the ISA. Furthermore, vibration isolation structures may also be incorporated within the ISA so that just some of the electronic components and sensors or even just the sensors are mechanically isolated from vibration.

In some embodiments each sensor die may be sealed exclusively within its own cavity by its own respective lid. In other embodiments (such as shown in Figure 4) multiple sensor die may be sealed within a common cavity by a single lid. Embodiments where multiple sensor die share a cavity and lid may provide space savings over embodiments that do not. However, cavities dedicated to individual sensor die may provide additional options for signal routing within the substrate 110 in other applications. Additional implementations for any embodiment described herein could utilize multiple substrate assemblies tiled together. For example, as illustrated in Figures 3 and 4, it might for some applications be desirable to build two substrate assemblies (shown at 301 and 302) so that one could be completed with a vacuum seal process while the other with a partial atmosphere process. The substrate assembles 301, 302 could then be assembled together in a later step into a single ISA 100.

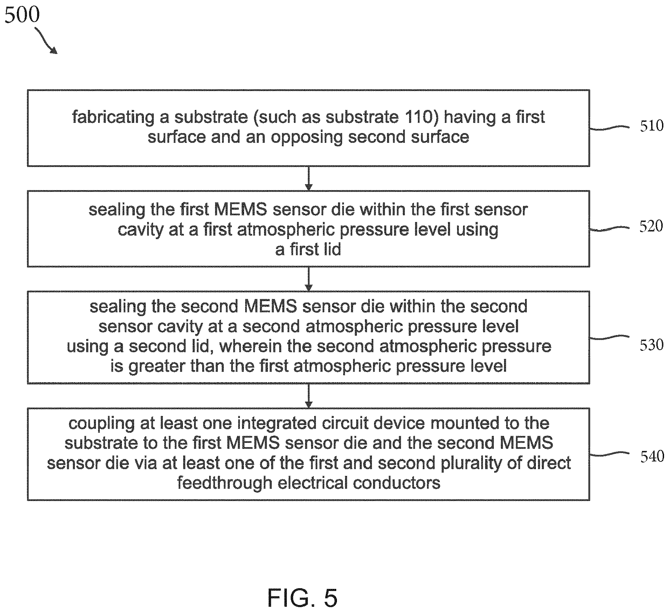

Figure 5 is a flow chart illustrating an example method 500 for fabrication/assembly of an ISA such as ISA 100, providing for differing atmospheric pressures for MEMS sensor die positioned in different cavities within substrate 110. It should be understood that the features and elements described herein with respect to Figure 5 may be used in conjunction with, in combination with, or substituted for elements of any of the other embodiments discussed herein, and *vice versa.* Further, it should be understood that the functions, structures and other description of elements for embodiments described herein may apply to like named or described elements for any of the Figures and *vice versa.*

The method 500 begins at 510 with fabricating a substrate (such as substrate 110) having a first surface and an opposing second surface. In one embodiment, the substrate comprises a plurality of sensor cavities recessed into the first surface, a first MEMS sensor die mounted within a first sensor cavity of the plurality of sensor cavities and electrically coupled to a first plurality of direct feedthrough electrical conductors embedded within the substrate, and a second MEMS sensor die mounted within a second sensor cavity of the plurality of sensor cavities and electrically coupled to a second plurality of direct feedthrough electrical conductors embedded within the substrate from the second MEMS sensor die.

It should, however, be noted that with any of the embodiments presented by this disclosure, it is not necessary for all of the plurality of sensor cavities and sensor die to be mounted on the same surface of the substrate. For example, one or more of the plurality of sensor die may be mounted in cavities on differing sides or surfaced of substrate 100. For example, in one embodiment one type of sensor, such as gyroscopes, may be positioned on a first side while a second type of sensor, such as accelerometers, may be positioned on a second side. It is also possible that such first and second sides need not be opposing surfaces of the substrate. For example a gyroscope may only measure rotation about an axis perpendicular to its surface. Thus, some embodiments may comprise a sensor cavity cut in vertically with respect to the top and bottom horizontal surfaces a substrate so that all three principal axes could be measured.

In one embodiment, the direct feedthrough electrical conductors may be designed to optimize sensor performance, such as by minimizing trace lengths or otherwise address electrical routing to reduce or minimalize induced cross-talk and/or parasitic capacitance that can introduce errors in measurement signals generated by the sensor die. The substrate may be built up in layers to form the direct feedthrough electrical conductors within the substrate material. The sensor cavities recessed into the substrate material may be fabricated to include one or more shelves, such as described above, to accommodate wirebond connections within the cavities and/or to facilitate a recess for the lids used to seal the cavities. In one embodiment, fabricating the cavities may include layering an electrical ground plane within the cavities and/or metalizing cavity floors. The sensor die may be electrically connected to the direct feedthrough electrical conductors via pads or other bonding points using one of any number of known die attachment methodologies such as, but not limited to a bump bond, underfilling, or other known methodology. Moreover, one or more wirebonds (which will be sealed within their respective sensor cavities) may be fabricated to electrically couple the sensor die to one or more of the direct feedthrough electrical conductors.

The method 500 then proceeds to 520 with sealing the first MEMS sensor die within the first sensor cavity at a first atmospheric pressure level using a first lid and to 530 with sealing the second MEMS sensor die within the second sensor cavity at a second atmospheric pressure level using a second lid, wherein the second atmospheric pressure is greater than the first atmospheric pressure level. In one embodiment, both the first and second cavities are initially sealed under the vacuum environment appropriate for the first MEMS sensor die. To then adjust the atmospheric pressure within the second cavity, a relief hole is opened within the second lid and the atmospheric pressure within the second cavity adjusted by backfilling the second cavity with a gas. The relief hole can then be sealed. Alternatively, in some embodiments, the first cavity may be sealed, for example under high vacuum. Then subsequently the second cavity is sealed while the substrate is exposed to a second environment.

The method proceeds to 540, which need not necessarily be performed after sealing of the cavities at 520 and/or 530. At 540, the method includes coupling at least one integrated circuit device mounted to the substrate to the first MEMS sensor die and the second MEMS sensor die via at least one of the first and second plurality of direct feedthrough electrical conductors. Other discrete electrical components may also be mounted to the substrate and electrically coupled to one or more of the MEMS sensor die via electrical conductors.

In some embodiments, the integrated circuit devices may comprise die mounted within separate cavities formed within the substrate and subsequently sealed. In some embodiments, solder paste may be applied to one or both of the first and/or second surfaces of the substrate and components (such as ASIC, processing units, an analog-to-digital converter, a digital-to-analog converter, active and/or passive electronic components, clocks or other sensors, for example) placed on the substrate and electrically coupled to the direct feedthrough electrical conductors. A completed inertial sensor assembly may then be mechanically attached to a mechanical isolation system (such as shown in Figure 3, for example) and installed within a housing for an IMU.

It should be understood that elements of the above described embodiments and illustrative figures may be used in various combinations with each other to produce still further embodiments which are explicitly intended as within the scope of the present disclosure.

### EXAMPLE EMBODIMENTS

Example 1 includes a sensor device, the device comprising: a substrate having a first surface and an opposing second surface; a plurality of sensor cavities recessed into the substrate; a first sensor die sealed within a first sensor cavity of the plurality of sensor cavities at a first atmospheric pressure level; a second sensor die sealed within a second sensor cavity of the plurality of sensor cavities at a second atmospheric pressure level that is a different pressure than the first atmospheric pressure level; a first plurality of direct feedthrough electrical conductors embedded within the substrate coupled to the first sensor die; and a second plurality of direct feedthrough electrical conductors embedded within the substrate coupled to the second sensor die.
Example 2 includes the device of example 1, wherein one or both of the first sensor die and the second sensor die comprise a micro-electromechanical (MEMS) sensor die.
Example 3 includes the device of any of examples 1-2, further comprising at least one integrated circuit device coupled to one or both of the first sensor die and the second sensor die via at least one of the first and second plurality of direct feedthrough electrical conductors.
Example 4 includes the device of any of examples 1-3, wherein the substrate comprises a ceramic substrate.
Example 5 includes the device of any of examples 1-4, wherein the first sensor die, the second sensor die and the substrate have matching thermal expansion properties.
Example 6 includes the device of any of examples 1-5, wherein the first plurality of direct feedthrough electrical conductors are embedded within the substrate from the first sensor die to a first set of electrical connector points positioned on the substrate; and wherein the second plurality of direct feedthrough electrical conductors are embedded within the substrate from the second sensor die to a second set of electrical connector points positioned on the substrate.
Example 7 includes the device of any of examples 1-6, wherein the first sensor die is electrically coupled to at least one of the first plurality of direct feedthrough electrical conductors by at least one wire bond sealed within the first sensor cavity; and wherein the second sensor die is electrically coupled to at least one of the second plurality of direct feedthrough electrical conductors by at least one wire bond sealed within the second sensor cavity.
Example 8 includes the device of any of examples 1-7, further comprising: a third cavity recessed into the substrate, wherein at least one other device die is sealed within the third cavity.
Example 9 includes the device of example 8, wherein the at least one other device die comprises an application specific integrated circuit (ASIC) die configured to condition electrical signals received and sent to at least one of the first sensor die and the second sensor die.
Example 10 includes the device of any of examples 8-9, wherein the third cavity is recessed into a surface of the substrate directly opposite either the first sensor die or the second sensor die.
Example 11 includes the device of any of examples 1-10, wherein the at least one other device die comprises a processing unit, an analog-to-digital converter, or a digital-to-analog converter.
Example 12 includes the device of any of examples 1-11, wherein one or both of the first sensor cavity and the second sensor cavity have sealed within it a plurality of sensor die.
Example 13 includes the device of any of examples 1-12, wherein one or both of the first sensor cavity and the second sensor cavity have sealed within it three sensor die having mutually orthogonally aligned measurement axes.
Example 14 includes the device of any of examples 1-13, wherein either the first sensor die or the second sensor die comprise a gyroscope sensor die, an accelerometer sensor die, a magnetometer sensor die, a temperature sensor die, a clock, or a pressure sensor die.
Example 15 includes the device of any of examples 1-14, the substrate comprising a first substrate assembly and a second substrate assembly coupled to the first substrate assembly, wherein the substrate assembly comprises the first sensor cavity and the second substrate assembly comprises the second sensor cavity.
Example 16 includes the device of any of examples 1-15, wherein the first sensor die is sealed within the first sensor cavity by a lid comprising a getter configured to scavenge gasses from the first sensor cavity.
Example 17 includes the device of any of examples 1-16, wherein the substrate is mounted within a housing via a mechanical isolation system, the mechanical isolation system comprising: a damped flexible suspension structure attached to both the substrate and an external structure.
Example 18 includes method for a sensor device, the method comprising: fabricating a substrate having a first surface and an opposing second surface, the substrate comprising: a plurality of sensor cavities; a first sensor die mounted within a first sensor cavity of the plurality of sensor cavities and electrically coupled to a first plurality of direct feedthrough electrical conductors embedded within the substrate; a second sensor die mounted within a second sensor cavity of the plurality of sensor cavities and electrically coupled to a second plurality of direct feedthrough electrical conductors embedded within the substrate from the second sensor die; sealing the first sensor die within the first sensor cavity at a first atmospheric pressure level using a first lid; sealing the second sensor die within the second sensor cavity at a second atmospheric pressure level using a second lid, wherein the second atmospheric pressure is different than the first atmospheric pressure level; and coupling at least one integrated circuit device mounted to the substrate to one or both of the first sensor die and the second sensor die via at least one of the first and second plurality of direct feedthrough electrical conductors.
Example 19 includes the method of example 18, wherein sealing the second sensor die within the second sensor cavity at the second atmospheric pressure level further comprises: sealing the second sensor die within the second sensor cavity at the first atmospheric pressure level; opening up a relief hole within the second lid; backfilling the second cavity with a gas to the second atmospheric pressure level; and sealing the relief hole.
Example 20 includes the method of any of examples 18-19, wherein the first plurality of direct feedthrough electrical conductors are embedded within the substrate from the first sensor die to a first set of electrical connector points positioned on the substrate; and wherein the second plurality of direct feedthrough electrical conductors are embedded within the substrate from the second sensor die to a second set of electrical connector points positioned on the substrate.

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the presented embodiments. Therefore, it is manifestly intended that embodiments be limited only by the claims and the equivalents thereof.

## Claims

1. A sensor device, the device comprising:
a substrate (110) having a first surface (201) and an opposing second surface (202);
a plurality of sensor cavities (101, 102) recessed into the substrate (110);
a first sensor die (210) sealed within a first sensor cavity (101) of the plurality of sensor cavities (101, 102) at a first atmospheric pressure level;
a second sensor die (212) sealed within a second sensor cavity (102) of the plurality of sensor cavities (101, 102) at a second atmospheric pressure level that is a different pressure than the first atmospheric pressure level;
a first plurality of direct feedthrough electrical conductors (114) embedded within the substrate (110) coupled to the first sensor die (210); and
a second plurality of direct feedthrough electrical conductors (114) embedded within the substrate (110) coupled to the second sensor die (212).

2. The device of claim 1, wherein one or both of the first sensor die (210) and the second sensor die (212) comprise a micro-electromechanical (MEMS) sensor die.

3. The device of claim 1, further comprising at least one integrated circuit device (215) coupled to one or both of the first sensor die (210) and the second sensor die (212) via at least one of the first and second plurality of direct feedthrough electrical conductors (114).

4. The device of claim 1, wherein the substrate (110) comprises a ceramic substrate (110).

5. The device of claim 1, wherein the first sensor die (210), the second sensor die (212) and the substrate (110) have matching thermal expansion properties.

6. The device of claim 1, wherein the first sensor die (210) is electrically coupled to at least one of the first plurality of direct feedthrough electrical conductors (114) by at least one wire bond sealed within the first sensor cavity (101) ;and
wherein the second sensor die (212) is electrically coupled to at least one of the second plurality of direct feedthrough electrical conductors (114) by at least one wire bond sealed within the second sensor cavity (102).

7. The device of claim 1 wherein one or both of the first sensor cavity (101) and the second sensor cavity (102) have sealed within it a plurality of sensor die.

8. The device of claim 1 wherein one or both of the first sensor cavity (101) and the second sensor cavity (102) have sealed within it three sensor die having mutually orthogonally aligned measurement axes.

9. A method for a sensor device, the method comprising:
fabricating a substrate (110) having a first surface (201) and an opposing second surface (202), the substrate (110) comprising:
a plurality of sensor cavities (101, 102);
a first sensor die (210) mounted within a first sensor cavity (101) of the plurality of sensor cavities (101, 102) and electrically coupled to a first plurality of direct feedthrough electrical conductors (114) embedded within the substrate (110);
a second sensor die (212) mounted within a second sensor cavity (102) of the plurality of sensor cavities (101, 102) and electrically coupled to a second plurality of direct feedthrough electrical conductors (114) embedded within the substrate (110) from the second sensor die (212);
sealing the first sensor die (210) within the first sensor cavity (101) at a first atmospheric pressure level using a first lid;
sealing the second sensor die (212) within the second sensor cavity (102) at a second atmospheric pressure level using a second lid, wherein the second atmospheric pressure is different than the first atmospheric pressure level; and
coupling at least one integrated circuit device (215) mounted to the substrate (110) to one or both of the first sensor die (210) and the second sensor die (212) via at least one of the first and second plurality of direct feedthrough electrical conductors (114).

10. The method of claim 9, wherein sealing the second sensor die (212) within the second sensor cavity (102) at the second atmospheric pressure level further comprises:
sealing the second sensor die (212) within the second sensor cavity (102) at the first atmospheric pressure level;
opening up a relief hole within the second lid;
backfilling the second cavity with a gas to the second atmospheric pressure level; and
sealing the relief hole.
